Europäisches Patentamt

European Patent Office

Office européen des brevets

(11) Veröffentlichungsnummer: **0 555 702 A2**

## (12) EUROPÄISCHE PATENTANMELDUNG

(21) Anmeldenummer: **93101324.7**

(22) Anmeldetag: **28.01.93**

(51) Int. Cl.5: **G01R 19/00**

(30) Priorität: **10.02.92 DE 4203801**

(43) Veröffentlichungstag der Anmeldung:
**18.08.93 Patentblatt 93/33**

(84) Benannte Vertragsstaaten:
**AT DE FR GB IT**

(71) Anmelder: **SIEMENS AKTIENGESELLSCHAFT**
**Wittelsbacherplatz 2**
**D-80312 München(DE)**

(72) Erfinder: **Thomas, Götze, Dipl.-Ing.**
**J.Marchlewski-Strasse 154**
**O-9026 Chemnitz(DE)**
Erfinder: **Slanina, Michael**
**Clausewitzstrasse 19**
**O-9000 Chemnitz(DE)**

(54) Schaltungsanordnung zur potentialfreien Messung eines gepulsten Gleichstroms.

(57) Bei der potentialfreien Messung von gepulsten Gleichströmen verfälscht die Magnetisierung des Eisenkerns eines Stromwandlers die Proportionalität zwischen Primär- und Sekundärstrom ($I_A$, $I'_A$). Zur Vermeidung der Magnetisierung des Wandlerkerns wird über eine Schaltungsanordnung aus Meßwiderstand (RM) und Differenzverstärkern (D1,D2) eine Spannung ($U_M$) erzeugt, die gleich ist den ohmschen Spannungsabfällen im Meßkreis und entgegengesetztes Vorzeichen aufweist.

FIG 1

Die Erfindung bezieht sich auf eine Schaltungsanordnung zur Messung des Stromflusses, insbesondere in Ventilzweigen von Stromrichterschaltungen. Dort werden bevorzugt induktive Stromwandler angewendet, an dessen Sekundäranschlüssen ein zum Primärstrom proportionaler Strom gemessen werden kann. Wenn die Verbraucher jedoch mit gepulstem Gleichstrom betrieben werden, ist eine Übertragung mittels konventioneller Stromwandler nicht ohne weiteres möglich, da der Gleichanteil der pulsförmigen Ströme den magnetischen Kreis des Stromwandlers sehr schnell sättigen würde. Als Folge davon geht die Proportionalität zwischen Primär- und Sekundärstrom verloren, so daß das sekundärseitige Signal für eine Strommessung unbrauchbar ist.

Aus der DD-PS 238 494 ist eine Schaltungsanordnung zum Regeln der Drehzahl eines elektrischen Motors in beiden Richtungen bekannt, bei der der Ankerstrom über induktive Wandler, deren Primärseiten in die Ventilzweige eingeschleift sind, erfaßt werden soll. Die Sekundärkreise der induktiven Wandler sind dabei mit einem Meßwiderstand und einem Differenzverstärker so beschaltet, daß während der Dauer eines Strompulses eine stromproportionale Spannung am Differenzverstärker abgegriffen werden kann. In der "Pausenzeit" des primärseitigen Stromflusses in einem Ventilzweig wird der jeweilige Sekundärstromkreis durch eine Schaltvorrichtung geöffnet und der betreffende Stromwandler über eine Spannungsbegrenzer-Diode abmagnetisiert. Diese Anordnung hat jedoch bei gegebenen Stromwandlerabmessungen eine obere Meßgrenze des Ankerstromes, ab der die Magnetisierung des Stromwandlers nicht mehr abgebaut werden kann. Das ist dann der Fall, wenn die Spannungszeitflache mit der der Stromwandler während der Übertragungsphase beaufschlagt wird, größer ist als die Spannungszeitfläche der Abmagnetisierungsphase.

Es ist deshalb Aufgabe der Erfindung, eine Schaltungsanordnung zur potentialfreien Messung eines gepulsten Gleichstroms mit großem Meßbereich zu erhalten.

Diese Aufgabe wird durch eine Schaltungsanordnung mit einem Primärstromkreis mit einem Verbraucher und mindestens einer Schaltvorrichtung zum Ein- und Ausschalten des zu messenden Primärstromes, mindestens einem Übertrager der jeweils primärseitig im Stromzweig einer Schaltvorrichtung liegt, einem Sekundärstromkreis, bestehend aus der Sekundärwicklung des Übertragers einem in Reihe dazu liegenden Meßwiderstand, der so mit einem ersten Operationsverstärker beschaltet ist, daß an seinem Ausgang eine zur Spannung am Meßwiderstand proportionale Spannung abgreifbar ist, wobei ein zweiter Operationsverstärker an seinem negativen Eingang mit dem Ausgangssignal des ersten Operationsverstärkers beaufschlagt wird, wobei der zweite Operationsverstärker als invertierender Verstärker so beschaltet ist, daß an seinem Ausgang eine zu den ohmschen Spannungsabfällen im Sekundärkreis proportionale Kompensationsspannung anliegt und wobei die Kompensationsspannung den Spannungsabfällen im Sekundärkreis entgegengeschaltet ist, gelöst. Durch die Beschaltung mit den Operationsverstärkern ist die erzeugte Kompensationsspannung immer betragsgleich zur Magnetisierungsspannung, auch wenn letztere Schwankungen aufweisen sollte. Somit wird eine aktive Bürde mit negativem Widerstand erzeugt, so daß die Magnetisierung im Stromwandler näherungsweise stromunabhängig und der Meßbereich wesentlich erweitert wird, ohne das bei gegebenen Vorrichtungen Änderungen am Stromwandler vorgenommen werden müssen. Sei gleichem Meßbereich können kleinere Baugrößen von Stromwandlern verwendet werden.

Vorteilhafter Weise kann der magnetisierende Spannungsabfall mit Hilfe einer Regelschaltung gemäß den Unteransprüchen weiter reduziert werden. Dazu wird mit Hilfe einer zusätzlichen Wicklung in den induktiven Wandlern eine Spannung gewonnen, die dem magnetisierenden Spannungsabfall direkt proportional ist. Diese Spannung wird verstärkt und zur Kompensation des magnetisierenden Spannungsabfalls benutzt.

Ein Ausführungsbeispiel der Erfindung ist in der Zeichnung dargestellt und wird im folgenden näher erläutert. Dabei zeigen:

FIG 1    eine Schaltungsanordnung zur induktiven Erfassung des Stromflusses in einer Stromrichteranordnung

FIG 2    eine Schaltungsanordnung zur induktiven Erfassung des Stromflusses in einer Stromrichteranordnung mit zusätzlichen Meßwicklungen.

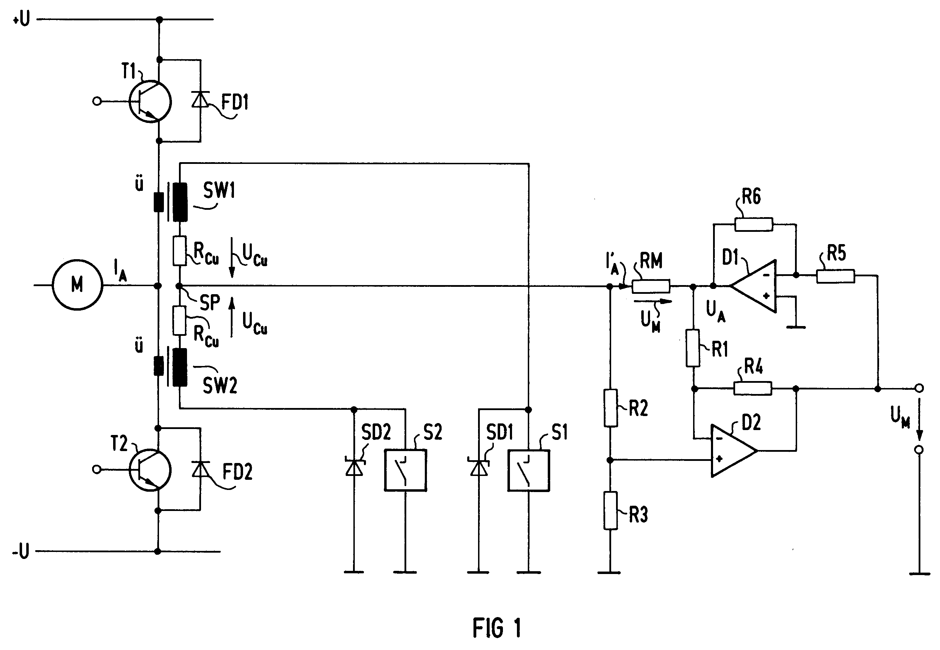

FIG 1 zeigt eine Schaltungsanodnung zur induktiven Erfassung des Stroms in einer Stromrichteranordnung. Von der Stromrichteranordnung, die beispielsweise eine Brückenschaltung zur Regelung eines Gleichstrommotors M sein kann, sind zwei Ventilzweige mit den Transistoren T1 und T2 gezeigt, zu denen jeweils eine Freilaufdiode FD1, FD2 parallel geschaltet ist. Der Transistor T1 liegt mit seinem Kollektor an der positiven Potentialleitung + U, der Transistor T2 liegt mit seinem Emitter an der negativen Potentialleitung - U. Der Kollektor des Transistors T1 und der Emitter des Transistors T2 sind jeweils über Primärwicklungen von Stromwandlern SW1, SW2 über einen gemeinsamen Anschlußpunkt mit dem Motor M verbunden. Die Primärwicklungen der Stromwandler SW1, SW2 sind im Ausführungsbeispiel kleiner gezeichnet, als die Sekundärwicklungen. Durch diese Darstellung soll verdeutlicht werden, daß es in der Regel ausreichend ist, die Primärwicklung der Stromwandler SW1, SW2 lediglich durch eine einzige Windung zu realisieren oder lediglich die isolierte Stromleitung durch den Übertragerkern hindurchzuschleifen. Die Basisanschlüsse der Transistoren T1, T2 führen zu einer nicht gezeigten Ansteuereinheit, die das zeitgerechte Schalten der Transistoren T1, T2 steuert.

Bei einem Anschluß des Motors an die negative Potentialleitung können der zweite Transistor T2 und die erste Freilaufdiode FD1, und bei einem Anschluß an die positive Potentialleitung können der erste Transistor T1 und die zweite Freilaufdiode FD2 entfallen, so daß die Anordnung dann als Ein-Quadrantensteller arbeitet. Außer an die negative und positive Potentialleitung kann der Motor aber auch an weitere Brücken angeschlossen werden, denn parallel zur Kombination aus dem ersten Transistor T1 und der ersten Freilaufdiode FD1 sowie aus dem zweiten Transistor T2 und der zweiten Freilaufdiode FD2 können entsprechend den Erfordernissen eine frei wählbare Anzahl gleicher Kombinationen ohne weitere schaltungstechnische Veränderungen angeordnet werden.

Jeweils ein sekundärseitiger Anschluß eines Stromwandlers SW1, SW2 ist an einen Summenpunkt SP geführt. Im Ausführungsbeispiel sind zwischen dem Summenpunkt SP und den Stromwandlern SW1, SW2 noch die Kupferwiderstände $R_{CU}$ der Sekundärwicklungen eingezeichnet. Der Summenpunkt SP ist mit einem Meßwiderstand RM verbunden, der parallel mit einem Differenzverstärker D2 beschaltet ist, wobei in dessen positiver Anschlußleitung der Widerstand R2 und in dessen negativer Anschlußleitung der Widerstand R1 liegt. Der Ausgang des Differenzverstärkers D2 ist über den Widerstand R5 mit dem negativen Eingang eines weiteren Differenzverstärkers D1 verbunden. Der positive Anschluß des Differenzverstärkers D1 ist auf Masse geführt. Damit ist der erste Differenzverstärker D1 als invertierender Verstärker beschaltet, wobei die Auslegung der Widerstände so gewählt ist, daß die am Ausgang des Differenzverstärkers D1 erzeugte Spannung entgegengesetzt gleich dem Spannungsabfall im Sekundärkreis ist. Da der Ausgang des Differenzverstärkers D1 auf den Meßwiderstand RM geführt ist, wird die Spannung im Sekundärkreis kompensiert.

Die beiden anderen Anschlüsse der Sekundärseiten der Stromwandler SW1, SW2, die nicht auf den Summenpunkt SP führen, sind jeweils über eine Parallelschaltung aus Spannungsbegrenzerdioden SD1, SD2 und elektronischen Schaltern S1, S2 auf Masse geführt.

Der zu messende Primärstrom, also der Ankerstrom $I_A$ des Motors M, fließt gemäß der Steuerung durch eine nicht gezeigte, da allgemein bekannte, Ansteuereinheit abwechselnd über den Transistorschalter T1 oder den Transistorschalter T2, und wird jeweils über den Stromwandler SW1 oder SW2 auf die Sekundärseite der Schaltungsanordnung übertragen. Damit fließt vom Summenpunkt SP über den Meßwiderstand RM ein dem Primärstrom $I_A$ proportionaler Sekundärstrom $I'_A$, der einen Spannungsabfall $U_M$ am Meßwiderstand RM bewirkt. Der Sekundärstrom $I'_A$ ist jedoch nur so lange proportional zum Primärstrom $I_A$, so lange die Eisenkerne der Stromwandler nicht magnetisiert sind. Es muß also dafür Sorge getragen werden, daß die Eisenkerne der Stromwandler SW1, SW2 möglichst nicht magnetisiert werden. Dabei macht man sich die Eigenschaft zu Nutze, daß die für die Magnetisierung der Eisenkerne veranwortliche Spannung stromproportional und proportional zu den übrigen ohmschen Verlusten im Sekundärkreis ist. Zu dem ohmschen Verlusten zählen nicht nur die Spannungsabfälle an den Kupferwiderständen $R_{CU}$ sondern beispielsweise auch die Spannungsabfälle an den elektronischen Schaltern S1 und S2.

Über die Anordnung aus Meßwiderstand RM und den Differenzverstärkern D1 und D2 kann eine Kompensationsspannung erzeugt werden, die den Spannungsabfällen im Sekundärkreis entgegengerichtet ist. Dazu wird die am Meßwiderstand RM abfallende Spannung $U_M$ mittels des Differenzverstärkers D2 gemessen, so daß sie am Ausgang des Differenzverstärkers D2 gegen Masse abgreifbar ist. Über den Widerstand R5 wird diese Spannung dem als invertierenden Verstärker beschalteten Differenzverstärker D1 zugeführt. Zwischen der Ausgangsspannung $U_A$ des Differenzverstärkers D1 und der Eingangsspannung $U_M$ besteht die Beziehung:

$$U_A = - (R_6/R_5) \, U_M \qquad (G1.1)$$

Macht man

$$R_6 = R_5 \, (R_M + R_{CU}) / R_M \qquad (G1.2)$$

und setzt für

$$U_M = I_A \, R_M/\ddot{u} \qquad (G1.3)$$

wobei ü das Übersetzungsverhältnis der Stromwandler SW1, SW2 ist, so erhält man

$$U_A = - (R_M + R_{CU}) \, I_A/\ddot{u} \qquad (G1.4)$$

also eine dem Primärstrom proportionale Ausgangsspannung $U_A$ des Differenzverstärkers D1 die dem magnetisierenden Spannungsabfall am jeweiligen Stromwandler SW1, SW2 entgegengerichtet ist. Die weitere, nicht näher erläuterte Beschaltung der Differenzverstärker D1, D2 gehört zum üblichen Wissen des Durchschnittsfachmannes, so daß sich eine detaillierte Erläuterung erübrigt.

Ideale Bauteile vorausgesetzt, würde die mit der bisher beschriebenen Schaltungsanordnung erzeugte Kompensationsspannung genau gleich dem magnetisierenden Spannungsabfall an den Stromwandlern SW1, SW2 sein, so daß es nicht mehr zu einer Magnetisierung der Stromwandlerkerne kommen kann. Bedingt durch die Toleranzen der Bauteile, die beispielsweise durch Temperaturschwankungen verursacht werden können, ist es jedoch möglich, daß sich ein Restmagnetisierungsstrom einstellt, der mit zunehmender Anzahl der Impulse wiederum zur Aufmagnetisierung der Wandlerkerne führt. Um diese Restmagnetisierung abzubauen, sind Parallelschaltungen, die jeweils aus einem elektronischen Schalter S1, S2 und einer Spannungsbegrenzerdiode SD1, SD2 bestehen im Sekundärkreis der Stromwandler SW1, SW2 vorgesehen. Ebenso wie die Transistorschalter T1, T2 im Primärkreis, werden die Schalter S1 und S2 im Sekundärkreis von der nicht gezeigten Ansteuereinheit gleichzeitig mit dem jeweiligen Transistor T1, T2 geschaltet. Wenn also der Transistor T1 durchgeschaltet wird, wird auch der Schalter S1 geschlossen, so daß im Sekundärkreis des Stromwandlers SW1 gemessen werden kann; wird der Transistorschalter T2 durchgeschaltet, dann wird auch der Schalter S2 und damit der Sekundärkreis des Stromwandlers SW2 geschlossen. Wenn entweder der Transistorschalter T1 oder der Transistorschalter T2 durch die Ansteuereinheit gesperrt werden, braucht im jeweils zugehörigen Sekundärstromkreis keine Messung vorgenommen werden, so daß gleichzeitig mit dem Transistorschalter T1 der Schalter S1 bzw. mit dem Transistorschalter T2 der Schalter S2 geöffnet werden kann. Die dabei im jeweiligen Sekundärkreis der Stromwandler SW1 oder SW2 entstehende Induktionsspannung wird dann über die zugehörige Spannungsbegrenzerdiode SD1 oder SD2 gegen Masse abgebaut und somit für eine Abmagnetisierung des jeweiligen Wandlerkerns gesorgt.

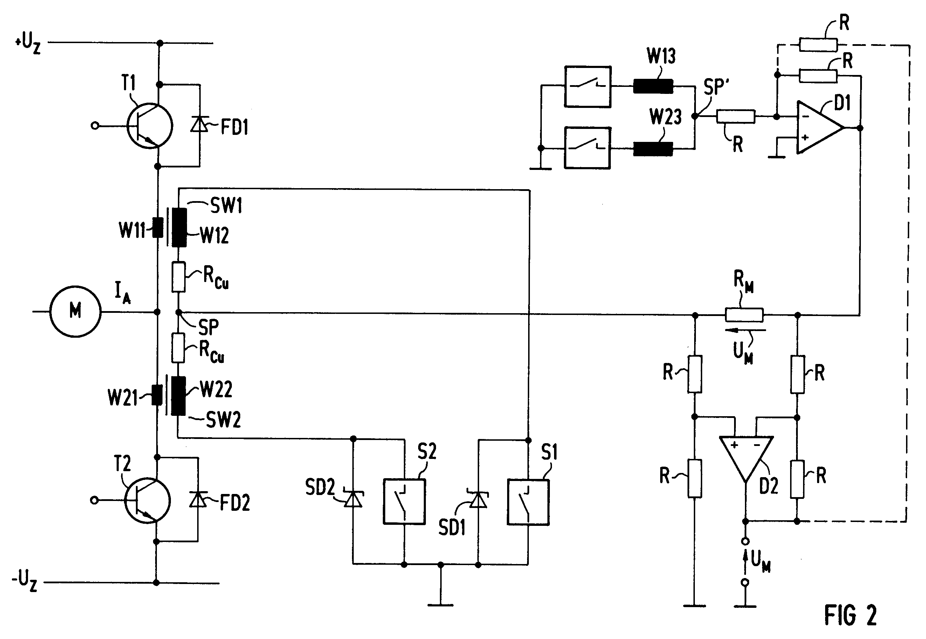

Im Ausführungsbeispiel gemäß FIG 2 ist eine Schaltungsanordnung zur induktiven Erfassung des Stromflusses in einer Stromrichteranordnung mit zusätzlichen Meßwicklungen gezeigt, bei der in den Stromwandlern SW1 und SW2 jeweils eine zusätzliche Wicklung W13, W23 vorgesehen ist. Die Primärwicklungen der Stromwandler SW1, SW2 sind mit W11 und W21, die Sekundärwicklungen mit W12 und W22 und die zusätzlichen dritten Wicklungen mit W13 und W23 bezeichnet. Die zusätzlichen Wicklungen W13 und W23 sind mit jeweils einem Ausgang auf einen Summenpunkt SP' geführt und von diesen über einen Widerstand R auf den negativen Eingang des integrierenden Verstärkers D1 geführt. Die anderen Anschlüsse der Wicklungen W13, W23 sind über Schalter S1' und S2' auf Masse geführt. Die Schalter S1' und S2' werden wie die Transistorschalter T1 und T2 und die Schalter S1 und S2 gleichzeitig über die nicht gezeigte Ansteuerungseinheit betätigt. Die übrige Schaltungsanordnung entspricht der Schaltungsanordnung aus FIG 1.

Werden die Transistorschalter T1 bzw. T2 durchgeschaltet, so wird mit Hilfe der Wicklungen W13 und W23 sowie der gleichzeitig mit den Transistorschaltern T1 bzw. T2 schließenden Schaltern S1' bzw. S2' eine Spannung gewonnen, die dem magnetisierenden Spannungsabfall direkt proportional ist. Diese Spannung wird über den Differenzverstärker D1 verstärkt und zur Kompensation des magnetisierenden Spannungsabfalles wie anhand der FIG 1 erläutert, benutzt. Am Ausgang des Differenzverstärkers D2 kann wieder die primärstromproportionale Spannung $U_M$ abgegriffen werden.

Im Ausführungsbeispiel gemäß FIG 2 ist zwischen dem Ausgang des Differenzverstärkers D2 und dem negativen Eingang des Differenzverstärkers D1 eine gestrichelte Verbindungslinie gezeichnet, in der ein weiterer Widerstand R liegt. Für die Funktionsweise der Schaltung ist diese Verbindung zwar nicht unbedingt erforderlich, sie kann jedoch als regelungstechnische Maßnahme benutzt werden um den Differenzverstärker D1 vorzusteuern.

## Patentansprüche

1. Schaltungsanordnung zur potentialfreien Messung eines gepulsten Gleichstroms mit:

   a) einem Primärstromkreis mit einem Verbraucher (M) und mindestens einer Schaltvorrichtung (T1,T2) zum Ein- und Ausschalten des zu messenden Primärstromes ($I_A$)

   b) mindestens einem Übertrager (SW) der primärseitig im Stromzweig einer Schaltvorrichtung (T1,T2) liegt,

   c) einem Sekundärstromkreis bestehend aus der Sekundärwicklung des Übertragers (SW), einem in Reihe dazu liegenden Meßwiderstand (RM) der so mit einem ersten Operationsverstärker (D1) beschaltet ist, daß an dessen Ausgang eine zur Spannung am Meßwiderstand (RM) proportionale Spannung ($U_M$) abgreifbar ist,

   d) einem zweiten Operationsverstärker (D2), der an seinem negativen Eingang mit dem Ausgangssignal des ersten Operationsverstärkers (D1) beaufschlagt wird,

   e) wobei der zweite Operationsverstärker (D2) als invertierender Verstärker so beschaltet ist, daß an seinem Ausgang eine zu den ohmschen Spannungsabfällen im Sekundärkreis proportionale Kompensationsspannung (UA) anliegt

f) und wobei die Kompensationsspannung ($U_A$) den Spannungsabfällen im Sekundärkreis entgegengeschaltet ist.

2. Schaltungsanordnung nach Anspruch 1, wobei
   a) wobei jeder Übertrager eine dritte Wicklung (W13,W23) aufweist, deren erster Anschluß über Schaltmittel (S1',S2') auf Massepotential geführt ist
   b) wobei der zweite Anschluß der dritten Wicklung auf den Eingang eines invertierenden Operationsverstärker (D1) geführt ist, der so beschaltet ist, daß an seinem, mit dem Meßwiderstand (RM) verbundenen Ausgang die Kompensationsspannung (UA) anliegt.

3. Schaltungsanordnung nach Anspruch 2, wobei der Ausgang des ersten Operationsverstärkers (D1) auf den negativen Eingang des zweiten Operationsverstärkers (D2) geführt ist.

4. Schaltungsanordnung nach einem der vorstehenden Ansprüche, wobei zwischen dem Massepotential und dem einen Anschluß der Sekundärwicklung des Stromwandlers (SW1,SW2) eine Parallelschaltung von Schaltmitteln (S1,S2) und einer spannungsbegrenzenden Diode (SD1,SD2) vorgesehen ist.

5. Schaltungsanordnung nach einem der vorstehenden Ansprüche, wobei in jedem Steuerstromzweig einer Brückenschaltung zur Drehzahlregelung eines elektrischen Motors (M) mindestens ein Stromwandler (SW1,SW2) vorgesehen ist, wobei jeweils ein Ausgang der Sekundärwicklung (W12,W22) über Schaltmittel (S1,S2) und jeweils eine parallel dazu angeordnete Spannungsbegrenzungsdiode (SD1,SD2) auf Massepotential geführt ist und wobei die zweiten Ausgange der Sekundärwicklung mit dem Neßwiderstand (RM) und den Mitteln zur Erzeugung der Kompensationsspannung verbunden sind.

FIG 1

6

FIG 2

EP 0 555 702 A2